# EUROPÄISCHE PATENTSCHRIFT

(11) **EP 0 208 328 B1**
(45) Veröffentlichungstag und Bekanntmachung des Hinweises auf die Patenterteilung: **27.04.1994**
(21) Anmeldenummer: 86109467.0
(22) Anmeldetag: 10.07.1986
(51) Int. Cl.: H03L 7/10

(54) **Dynamisches Regelungssystem**
Dynamic control system
Système de régulation dynamique

(30) Priorität: 11.07.1985 DE 3524800
(43) Veröffentlichungstag der Anmeldung: 14.01.1987
(73) Patentinhaber: SIEMENS AKTIENGESELLSCHAFT, 80333 München (DE)
(72) Erfinder: Draxelmayr, Dieter, Dipl.-Ing., A-9500 Villach (AT)

(56) Entgegenhaltungen:
- DE-A- 2 046 990
- DE-A- 3 023 408
- DE-A- 3 120 930
- FR-A- 2 515 376
- US-A- 3 909 735
- US-A- 4 205 272
- US-A- 4 319 173
- US-A- 4 482 869
- US-A- 4 516 083
- PATENT ABSTRACTS OF JAPAN, Band 6, Nr. 108 (P-123)(986), 18. Juni 1982;& JP-A-55115309
- PATENT ABSTRACTS OF JAPAN, Band 10, Nr. 101 (P-447)(2158), 17. April 1986;& JP-A-5990363

## Beschreibung

Die Regelungstechnik hat für ihre Aufgabe, das Zeitverhalten dynamischer Systeme in gezielter Weise zu beeinflussen, eine Vielzahl verschiedener Methoden parat. Dabei sollen bestimmte zeitveränderliche Großen des Systems auf vorgegebene Zeitverläufe gebracht und dort gehalten werden. Grundsätzlich geschieht dies durch eine Beobachtung der Ausgangsgrößen des Systems und eine Veränderung der Eingangsgrößen des Systems aufgrund der gewonnenen Informationen. In dem Buch "Regelungstechnik" von Otto Föllinger, Elitera-Verlag Berlin, 1972, werden grundlegende Strukturen und Verfahren für lineare una zeitinvariante Systeme mit konzentrierten Parametern unter dem Einfluß deterministischer Eingangsgrößen behandelt.

Viele der dort geschilderten Verfahren lassen sich auch auf nichtlineare und zeitvariante Systeme übertragen, sofern diese sich zumindest in gewissen Bereichen linearisieren lassen. Erstreckt sich der Betriebsbereich eines Systems über diese linearisierten Bereiche hinaus oder treten Totzeiten, verteilte Parameter oder stochastische Störgrößen auf oder ist einfach die Ordnung eines Regelungssystems sehr verwickelt, beispielsweise durch Verkoppelung der Größen, so läßt sich oft nicht einmal die unabdingbare Forderung nach Stabilität des Regelkreises gegenüber den Sollgrößen und den Störgrößen verwirklichen. Weitergehende Forderungen an die Regelungscharakteristik, beispielsweise an ein optimales Einschwingverhalten, eine Parameteroptimierung oder eine Regelung auf endliche Einstellzeit, im besonderen auf eine schnelligkeitsoptimale Regelung scheiden damit von vornherein aus.

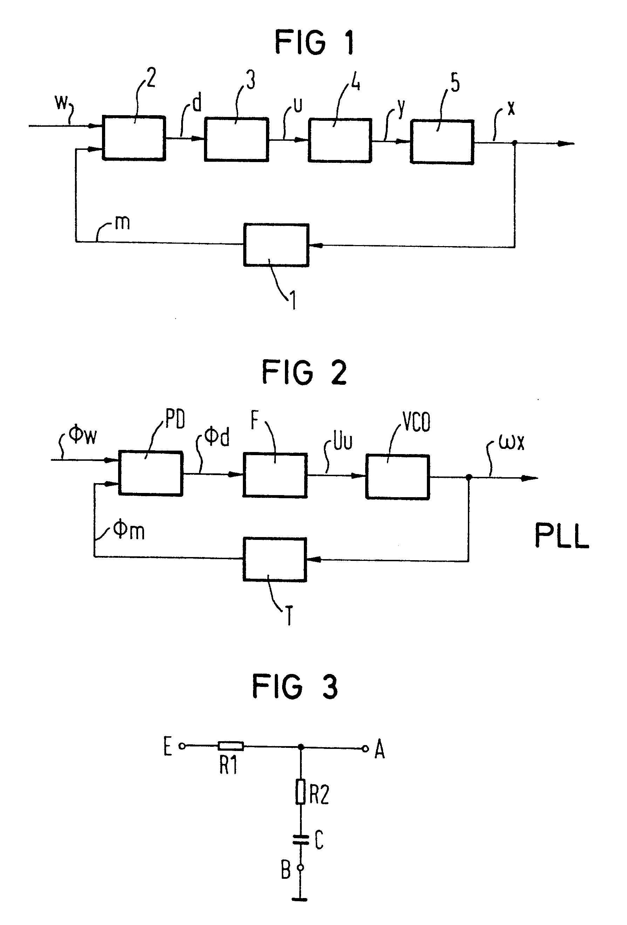

Fig. 1 zeigt das Blockschaltbild eines Regelkreises eines dynamischen Regelungssystem. Mit Hilfe einer Erfassungs oder Meßeinrichtung 1 wird eine Regelgröße x erfaßt und eine Meßgröße m abgeleitet, die in einer Vergleichseinrichtung 2 mit einer Sollgröße w verglichen wird. In der Vergleichseinrichtung 2 wird eine Regeldifferenz d gebildet, aus der im Sinne einer zu erzielenden Regelcharakteristik des Regelkreises mit Hilfe einer Korrektureinrichtung 3 und einer Stelleinrichtung 4 eine Steuergröße u bzw. Stellgröße y abgeleitet wird, die auf die Regelstrecke 5 mit der Regelgröße x als Ausgangsgröße wirkt. Fallweise vereinfacht sich dieser Regelkreis, wenn beispielsweise die Regelgröße x ohne meßtechnische Umwandlung direkt als Eingangsgröße der Vergleichseinrichtung 2 dienen kann oder wenn für die Ansteuerung der Regelstrecke 5 keine Stelleinrichtung 4 erforderlich ist, d.h. wenn die Steuergröße u direkt als Stellgröße y auf die Regelstrecke einwirken kann. Ein dynamisches Regelungssystem kann grundsätzlich ein erheblich verwickelteres Blockschaltbild aufweisen, in dem mehrere Regelkreise nach Fig. 1 miteinander und/oder mit anderen Größen des dynamischen Regelungssystems verkoppelt sein können.

Als konkretes Ausführungsbeispiel eines Regelkreises stellt Fig. 2 das Blockschaltbild eines phase-locked Loops (PLL) dar. Die Vergleichseinrichtung ist in Fig. 2 durch einen Phasendetektor PD gebildet, die Korrektureinrichtung durch ein Schleifenfilter F, die Stelleinrichtung mit Regelstrecke durch einen spannungsgesteuerten Oszillator VCO (voltage controlled oscillator) und die Erfassungs- bzw. Meßeinrichtung durch einen Frequenzteiler T. Der PLL versucht, die erfaßte Phase φm der Frequenz ωx des Ausganssignals der Phase φw der Referenzfrequenz so nachzuregeln, daß die Phasendifferenz φd immer einen definierten Wert, insbesondere Null oder 90 °, annimmt. Eingangsgrößen des Phasendetektors PD können auch die Referenzfrequenz selbst und die erfaßte Ausgangsfrequenz sein. Bei stabilem Betriebsverhalten des PLL ist dann die Frequenz ωx des Ausgangssignals des VCO mit der Frequenz des Referenzsignals synchronisiert, der PLL ist "locked in" oder "eingerastet". Dabei kann die Frequenz ωx des Ausgangssignals durchaus ein Vielfaches oder ein Bruchteil der Frequenz des Eingangssignals betragen. In einem derartigen Fall paßt der Frequenzteiler T das für den Phasendetektor PD benötigte Signal φm dem Phasensignal φw des Referenzsignals an. Beispiele für einen VCO stellen ein Schmitt-Trigger mit zu regelnder Kippfrequenz oder ein Motor mit zu regelnder Drehzahl dar.

Bei einer Änderung des Teilerverhältnisses des Frequenzteilers T oder bei einer Änderung der Referenzfrequenz muß der PLL die erneute Synchronisierung des Referenzsignals mit dem Ausgangssignal gewährleisten, selbst wenn der Regelkreis kurzzeitig ausrasten darf. Andererseits gibt es Anwendungen, in denen PLL-Schaltungen, die sich sowohl digital als auch analog realisieren lassen, nicht zu weit ausrasten dürfen, um Impulse oder Schwingungen nicht zu unterdrücken. Der Fangbereich einer PLL-Schaltung liegt in einem bestimmten Frequenzbereich um die Mittenfrequenz des PLL. Der Haltebereich einer PLL erstreckt sich dagegen über einen wesentlich weiteren Frequenzbereich. Fangbereich und Haltebereich geben an, bei welcher Frequenz ein ausgerasteter PLL synchronisiert bzw. ein eingerasteter PLL außer Tritt gerät. Unter der Mittenfrequenz versteht man die Frequenz, bezüglich der eine Modulation stattfinden kann. Weitere Synchronisierbereiche können bei Harmonischen oder Subharmonischen der Referenzfrequenz auftreten, wobei allerdings die zugehörigen Halte- und Fangbereiche in der Regel kleiner werden.

Besonders bei tiefen Frequenzen bezüglich der Mittenfrequenz und bei Frequenzvervielfacher-Schaltungen können Stabilitätsprobleme entstehen, die sich als Phasenjitter bzw. Phasenschwankungen äußern. Besonders bei einer eventuell erforderlichen geringen Dämpfung oder einer Überkompensation kann eine Schwingneigung auftreten. Bei Frequenzvervielfacher Schaltungen, insbesonder mit großem Teilungsverhältnis, ist Phasenstabilität generell nur sehr schwer zu erreichen, da immer bereits mehrere Perioden des Ausgangssignals verstrichen sind, bevor über den Phasendetektor PD und die Korrektureinrichtung nachgeregelt werden kann.

Auch in einfachereren PLL-Schaltungen können insbesondere durch Nichtlinearitäten, Totzeiten oder Unsymmetrien Schwingneigungen entstehen. Eine solche Schaltung ergibt sich aus Fig. 2 beispielsweise dadurch, daß der Frequenzteiler T entfällt und die Ausgangsfrequenz des VCO direkt auf den Phasendetektor PD zurückgeführt wird. Ausgangsgröße des Regelkreises kann, ebenso wie in dem Blockschaltbild nach Fig. 2, sowohl die Ausgangsfrequenz des VCO als auch dessen Steuerspannung Uu sein. Bildet die Steuerspannung Uu für den VCO selbst die Ausgangsgröße, so können sich parasitäre Eigenschaften des VCO direkt auf die Stabilität des Kreises auswirken.

In vielen Fällen kann durch eine Optimierung des Schleifenfilters F und der VCO-Beschaltung in begrenzten Bereichen Stabilität erreicht werden. Diese optimierte Beschaltung ist im allgemeinen jedoch nur in einem relativ engen Bereich gültig und insbesondere beispielsweise bei einem integrierten Schaltkreis für allgemeine kundenspezifische Anforderungen nicht sinnvoll.

Der Phasendetektor PD wird in analogen Systemen durch ein Multiplizierernetzwerk und in digitalen Systemen durch Gatter, beispielsweise NAND- oder EXOR-Gatter gebildet. Das im Zuge des Signalswegs folgende Schleifenfilter F besitzt Tiefpaßcharakteristik, um höher frequente Signalschwingungen auszublenden. Das Schleifenfilter F ist üblicherweise ein in Fig. 3 dargestelltes PI-Glied, wobei P und I für eine proportionale und integrierende Funktionsweise stehen. Der Signaleingang E des Filters ist über den Widerstand R1 mit dem Ausgang A verbunden, der wiederum durch die Serienschaltung eines Widerstandes R2 und einer Kapazität C an einem ein Bezugspotential führenden Anschluß B liegt. Andere, insbesondere aktiv arbeitende Ausgestaltungen des Schleifenfilters F sind üblich.Bei der Dimmensionierung eines derartigen Filters F ist zu beachten, daß es für tiefe Frequenzen gerade noch integrierend wirken muß, wozu die Kapazität C möglichst groß gewählt werden soll. Diese die stationäre Genauigkeit des Regelkreises beeinflussende Maßnahme steht allerdings im Gegensatz zur Forderung nach einer schnellen Regelung für hohe Frequenzen, die ein proportionales Regelverhalten und damit eine kleine Kapazität C erfordert, damit sich in Verbindung mit dem Widerstand R1 eine geringe Zeitkonstante ergibt. Der Widerstand R2 ist ein Dämpfungswiderstand.

Unter der Voraussetzung, daß ein PLL-Regelkreis nach Fig. 2 mit einem Schleifenfilter F nach Fig. 3 bei der regelungstechnischen Behandlung linearisiert und zeitkontinuierlich aufgefaßt werden kann, ist die Schaltung generell nur dann stabil, solange die Dämpfung groß genug ist, d.h. solange der Widerstand R2 nicht gegenüber dem Widerstand R1 vernachlässigbar klein ist. Daraus folgt eine Neigung zur Instabilität bei Anwendungen, in denen eine geringe Dämpfung erzwungen wird. Das Verhalten des Regelkreises wird in der Regel noch dadurch verschlechtert, daß die nichtidealen, physikalisch realen Eigenschaften der Elemente des Kreises bei der Dimmensionierung des Schleifenfilters F nicht vollständig berücksichtigt werden können.

Stabiles Verhalten stellt allerdings nur die Grundforderung an ein dynamisches Regelungssystem dar. In fast allen Anwendungsfällen werden weitergehende Forderungen gestellt, um eine bestimmte Systemcharakteristik zu erreichen. Insbesondere bei Regelungssystemen, die einen weiten Anwendungsbereich abdecken müssen oder in denen eine Optimierung erforderlich ist, können diese Ansprüche oft nur schwer oder gar nicht mit Regelkreisen nach Fig. 1 erreicht werden. Als weitere Ausführungsbeispiele können in diesem Zusammenhang eine schnelligkeitsoptimale Lageregelung mit nichtlinearen Elementen oder eine Verstärkungsregelung mit Totzeitgliedern erwähnt werden. Bei der schnelligkeitsoptimalen Lageregelung soll ein zu regelndes Element mit Hilfe eines Stellmotors in eine bestimmte Lage gebracht werden, wozu der Stellmotor mit maximaler Geschwindigkeit betrieben wird, bis das Element in der Näher der Endlage angelangt ist, anschließend soll der Stellmotor mit nunmehr optimaler Geschwindigkeit die Endlage ansteuern. Bei einem Verstärkungsregelkreis mit Totzeit ist dagegen eine Konstantstromladung oder -entladung beispielsweise großer Kapazitäten denkbar, sobald starke Schwankungen der Versorgungsspannung auftreten, während beim regulären Betrieb ein mit konventionellen Mitteln beherrschbares Verhalten gewünscht wird.

Vorstehend beschriebene dynamische Regelungssysteme besitzen eine Steuergröße u, die eine Funktion der Zeit, des Parametervektors der Regelstrecke oder des Zustandsvektors des Regelungssystems ist. Diese Parameter beeinflussen alternativ die Parameter einer Korrektureinrichtung 3 nach Fig. 1, die wie beschrieben nur in gewissen Grenzen optimiert werden können.

Der Erfindung liegt die Aufgabe zugrunde, ein dynamisches Regelungssystem anzugeben, das in einem weiten Arbeitsbereich wenigstens eine vorzugebende Systemcharakteristik besitzt.

Diese Aufgabe wird bei einem dynamischen Regelungssystem der eingangs genannten Art erfindungsgemäß durch die Merkmale des Patentanspruchs 1 gelöst.

Der Grundgedanke eines erfindungsgemäßen Regelungssystems besteht darin, die Regelparameter der Korrektureinrichtung zeit,- zustands- oder parametergesteuert so zu variieren, daß sich eine vorgegebene Charakteristik des Regelverhaltens ergibt. Dazu enthält die Korrektureinrichtung mindestens zwei Funktionsgruppen mit unterschiedlichen Charakteristiken, von denen wenigstens eine nicht dauernd zur Ableitung der Stellgröße im Signalweg der Regeldifferenz liegt.

Der Erfindungsrahmen umfaßt auch eine zeit-, zustands- oder parametergesteuerte Variation der Parameter der Stelleinrichtung oder der Stelleinrichtung mit Regelstrecke, beispielsweise ihrer Eingangsschaltung. Alternativ oder ergänzend zur Korrektureinrichtung enthalten dann diese Blöcke mindestens zwei Funktionsgruppen mit unterschiedlichen Charakteristiken, von denen wenigstens eine nicht dauernd zur Ableitung der Stellgröße im Signalweg der Regeldifferenz liegt.

Anwenden läßt sich die Erfindung auf Regelungskreise mit genereller Struktur, die beispielsweise durch einen Parametervektor oder einen Zustandsvektor beschrieben werden können. Darunter fallen adaptive Regelungssysteme, bei denen die Parameter der Korrektureinrichtung so auf Parameter der Regelstrecke abgestimmt werden, daß ein Gütekriterium mit einem vorgeschriebenen Wert oder einem Extremwert erreicht wird, wobei die Regelparameter in Abhängigkeit vom augenblicklichen Zustand der Regelstrecke variiert werden können.

Ein Zustandsvektor enthält Zustandsvariable als Elemente, das sind orts- und zeitabhängige Größen. Die Zustandsvariablen ergeben sich aus einer bestimmten Anzahl ortsabhängiger Funktionen, die den augenblicklichen Zustand eines Systems zu einem gegebenen Zeitpunkt vollständig beschreiben, unter Berücksichtigung der sich gemäß den physikalischen Gegebenheiten des Systems mit fortschreitender Zeit ergebenden Veränderungen dieser Funktionen. Zustandsvariable lassen sich vorteilhaft in einem erfindungsgemäßen dynamischen Regelungssystem auch bei nichtlinearen, zeitvarianten und totzeitbehafteten Größen einsetzen.

Weitere Ausgestaltungen des Erfindungsgedankens sind in Unteransprüchen gekennzeichnet.

Die Erfindung wird nachfolgenden anhand in den Figuren der Zeichnungen dargestellter Ausführungsbeispiele näher erläutert. Gleiche Elemente sind in den Figuren mit gleichen Bezugszeichen versehen.

Es zeigt:
- Fig. 4: ein Blockschaltbild eines Ausführungsbeispieles eines erfindungsgemäßen dynamischen Regelungssystems,
- Fig. 5: ein Blockschaltbild eines PLL-Regelkreises als konkreter Ausführungsform eines Regelungssystems nach Fig. 4,
- Fig. 6: ein Diagramm zur Erläuterung der Funktionsweise eines analog arbeitenden Regelungssystems nach Fig. 5,
- Fig. 7: ein Diagramm zur Erläuterung der Anforderungen an das Dämpfungsverhalten der Korrektureinrichtung eines zeitdiskreten digitalen Regelkreises nach Fig. 5,
- Fig. 8 a und b: zwei Diagramme zur Erläuterung des Regelverhaltens eines zeitdiskreten digitalen Regelkreises nach Fig. 5,
- Fig. 9: ein Prinzipschaltbild eines spannungsgesteuerten Oszillators,
- Fig.10 b und c: Ausführungsformen einer erfindungsgemäßen umschaltbaren spannungsgesteuerten Referenzstromquelle im Vergleich mit einer in Fig. 10a dargestellten spannungsgesteuerten Referenzstromquelle nach dem Stand der Technik und
- Fig. 11: ein Schaltbild einer konkreten Ausführungsform eines VCO mit erfindungsgemäßer Eingangsschaltung.

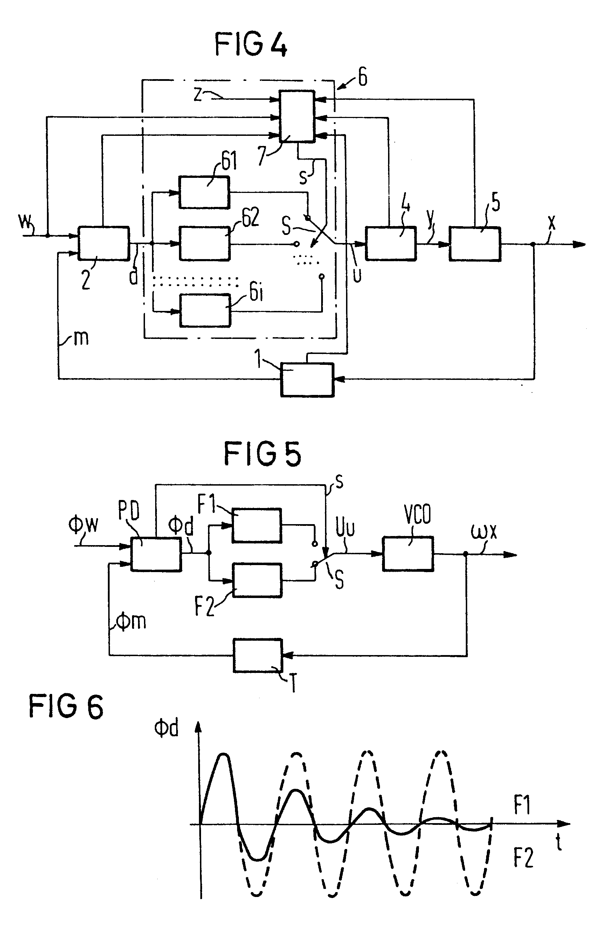

Fig. 4 unterscheidet sich von Fig. 1 in der Ausgestaltung der Korrektureinrichtung. Während die Korrektureinrichtung 3 nach Fig. 1 eine Funktionsgruppe mit einer Charakteristik enthält, besitzt die erfindungsgemäße Korrektur einrichtung 6 nach Fig. 4 mindestens zwei Funktionsgruppen mit unterschiedlichen Charakteristiken. Diese sind durch die Funktionsgruppen 61 und 62 symbolisiert und können z.B. Tiefpaßcharakter besitzen, wobei eine der beiden Funktionsgruppen 61 oder 62 unbedämpft die andere mit Dämpfung auf die Regeldifferenz d wirken kann. Durch Punktreihen und einen Zweig mit einer Funktionsgruppe 6i wird angedeutet, daß die Korrektureinrichtung 6 weitere Funktionsgruppen enthalten kann, die zur Ableitung der Steuergröße u aus der Regeldifferenz d dienen.

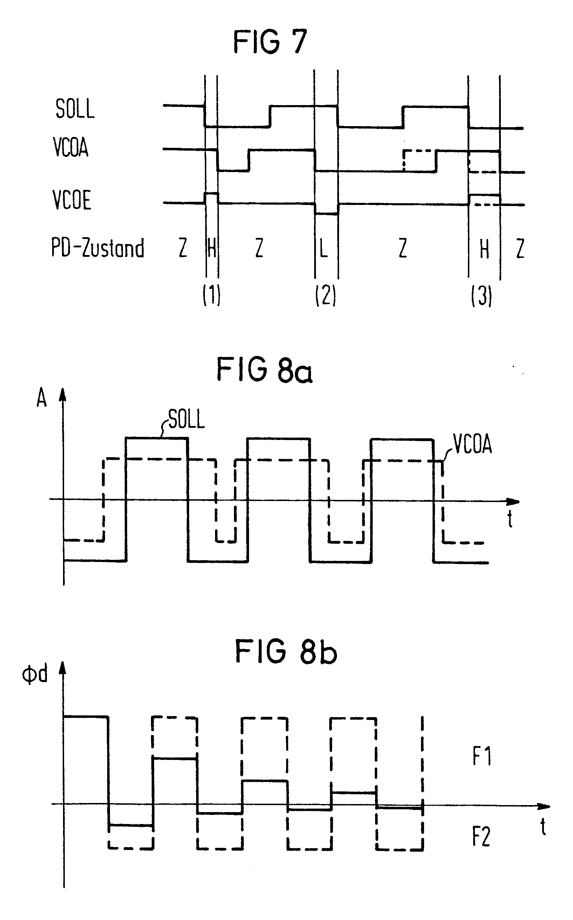

Alternativ oder ergänzend enthält die Stelleinrichtung 4 mindestens zwei Funktionsgruppen mit unterschiedlichen Charakteristiken, z. B. verschiedene Eingangsschaltungen zur Ableitung der Stellgröße y aus der Regeldifferenz d obwohl ein derartiges Ausführungsbeispiel in Fig. 7 nicht skizziert ist.

Erfindungsgemäß liegt nun wenigstens eine der Funktionsgruppen, z. B. 61, 62 bis 6i nicht dauernd im Signalweg der Regeldifferenz d. Dazu dient im Ausführungsbeispiel nach Fig. 4 der gesteuerte Schalter S, der jeweils nur eine Funktionsgruppe, im Beispiel die Gruppe 61, in den Signalweg schaltet. Als gesteuerter Schalter kommen dabei alle an sich bekannten Schalterformen, beispielsweise mechanische, hydraulische oder elektronische in Frage. Das Umschaltsignal s wird von einer Schalteinrichtung 7 abgeleitet, die je nach der zu erzielenden Gesamtcharakteristik des Regelkreises relevante Eingangsgrößen aufweist, die von den anderen Blöcken oder Größen des dynamischen Regelungssystems, beispielsweise der Führungsgröße w, der Erfassungs- oder Meßeinrichtung 1, der Vergleichseinrichtung 2, der Stelleinrichtung 4 und der Regelstrecke 5 abgeleitet werden. Zusätzlich können äußere Störgrößen z das Schaltkriterium beeinflussen.

Die Umschaltgröße s kann dann eine Funktion der Zeit, des Zustandsvektors oder eines Parametervektors sein. Auf diese Weise können Optimierungskriterien über den Schalter S direkte Einflüsse auf das Regelungsverhalten bzw. die Korrektureinrichtung 6 gewinnen. Es liegt im Rahmen der Erfindung, daß eine oder mehrere der Funktionsgruppen gleichzeitig, vorteilhaft mit einer Gewichtung versehen, zur Ableitung der Stellgröße y dienen. Neben der in Fig. 4 dargestellten Parallelschaltung der Funktionsgruppen 61, 62 bis 6i kommt für deren Anordnung auch eine Serien- Parallelschaltung, insbesondere mit einer erfindungsgemäßen Stelleinrichtung 4, in Frage. Erfindungswesentlich ist, daß wenigstens eine der Funktionsgruppen die Stellgröße y nicht dauernd beeinflußt. Die Schaltgröße s kann neben einer diskreten Umschaltung, bei der auch unterschiedliche Kombinationen der Funktionsgruppen in den Erfindungsrahmen fallen, eine kontinuierliche Umschaltung vorsehen. Dieser Fall liegt oft bei nichtidealen Schaltercharakteristiken vor.

Es ist für ein erfindungsgemäßes dynamisches Regelungssystem unerheblich, ob die konkrete Ausführungsform als Digital- oder Analogsystem konzipiert ist. Als Ausführungsbeispiele eines derartigen Regelungssystems lassen sich unter anderem die bereits erwähnte geschwindigkeitsoptimale Lageregelung oder die Verstärkerschaltung mit Totzeit anführen. Ausführlich soll jedoch auf eine bereits in Fig. 2 grundsätzlich erläuterte PLL-Schaltung eingegangen werden.

Fig. 5 zeigt ein Blockschaltbild eines Ausführungsbeispiels einer erfindungsgemäßen PLL-Schaltung. Vom Blockschaltbild nach Fig. 2 unterscheidet sich die Fig. 5 dadurch, daß die Phasendifferenz φd nicht auf ein einziges Schleifenfilter F, sondern auf zwei Filter F1 und F2 geführt ist. Mit Hilfe eines Schalters S wird zwischen beiden Schleifenfiltern zur Ableitung der Steuergröße Uu umgeschaltet; die Steuergröße s für den Schalter S wird in Fig. 5 aus dem Phasendetektor PD abgeleitet. Abhängig von bestimmten Betriebszuständen kann zur Erreichung eines verbesserten Betriebsverhaltens auf die optimale Filtercharakteristik umgeschaltet werden.

Alternativ oder ergänzend kann die Stelleinrichtung mit Regelstrecke, im Ausführungsbeispiel nach Fig. 5 der spannungsgesteuerte Oszillator VCO, zwei Funktionsgruppen mit unterschiedlicher Charakteristik, insbesondere zwei Eingangsschaltungen aufweisen, zwischen denen umgeschaltet werden kann. Das Schleifenfilter F kann in diesem Fall nach dem Stand der Technik ausgelegt sein oder ein Integrier- oder Halteglied, z.B. eine Kapazität enthalten.

Obwohl es sich nach Fig. 5 um ein nichtlineares, zeitvariantes Netzwerk handelt, läßt sich eine derartige PLL-Schaltung in einem weiten Arbeitsbereich, insbesondere bei tiefen Frequenzen, Unsymmetrien, Totzeiten und Nichtlinearitäten vorzugsweise zur Verbesserung des Stabilitätsverhaltens einsetzen. Eine derartige Schaltungsanordnung ist bevorzugt geeignet für digitale PLL-Schaltungen, aber auch für analoge PLL. Grundvoraussetzung ist in jedem Fall, daß die Schaltgeschwindigkeit des gesteuerten Schalters S gegenüber dem Verhalten der übrigen Regelkreisglieder ausreichend groß ist, damit Einflüsse durch die Umschaltung des Schalters S selbst gering bleiben.

Eine allgemeine mathematische Beschreibung einer PLL-Schaltung nach Fig. 5 ist schwierig, da es sich um ein nichtlineares zeitvariantes System handelt. Für die Anschauung genügt es allerdings, Gas System zu linearisieren und quasi kontinuierlich zu betrachten. Dann gibt es gewisse Zeitbereiche, in denen das System mit der linearen Regelungstheorie nach dem Stand der Technik behandelt werden kann und in denen das Verhalten des realen physikalischen Systems zutreffend wiedergegeben wird.

Zur Erläuterung eines derartigen quasikontinuierlich angesehenen Systems dient das Diagramm nach Fig. 6, in dem die Phasendifferenz φd über der Zeit t aufgetragen ist. Dabei wird angenommen, daß die Umschaltung zwischen den Filtern F1 und F2 abhängig vom Vorzeichen der Phasendifferenz φd erfolgt. Beide Filter sollen ein Tiefpaßverhalten zeigen, und können entweder passiv entsprechend Fig. 3 oder aktiv aufgebaut sein. Sie unterscheiden sich lediglich dadurch, daß das Filter F1 keine Dämpfung zeigt, das Filter F2 dagegen dämpft.

In Fig. 6 gibt die gestrichelt gezeichnete Linie den zeitlichen Verlauf des Phasenfehlers φd für den Fall wieder, daß nur ein Filter ohne Dämpfung vorhanden ist. Erkennbar bleibt die Amplitude des Phasenfehlers φd, d.h. der Refeldifferenz, im zeitlichen Verlauf erhalten, so daß der Regelkreis weder dynamisch noch stationär stabil ist. Schaltet dagegen der Schalter S zum richtigen Zeitpunkt von der ungedämpften Filtercharakteristik des Filters F1 auf die gedämpfte Charakteristik des Filters F2 um, so wird die Gesamtschwingung gedämpft. Im Diagramm nach Fig. 6 wird dazu bei negativen Phasen fehlern die Charakteristik des Filters F2, bei positiven Fehlern die Charakteristik des Filters F1 eingeschaltet. Den dann gedämpften Verlauf des Phasenfehlers gibt die durchgezogene Linie wieder, aus der ein stabiles Verhalten des Regelkreises erkennbar wird. Während bei diesem Beispiel für das Betriebsverhalten ein labiles oder instabiles Verhalten des Regelkreises bei geringer Dämpfung auftritt, zeigt Fig. 7 ein Diagramm für einen Betriebsfall, in dem eine permanente starke Dämpfung zur Instabilität führt.

Fig. 7 zeigt ein Beispiel für eine zeitdiskrete Schwingung einer digitalen PLL-Schaltung. Als Phasendetektor PD dient ein Netzwerk, das drei mögliche Ausgangszustände erzeug. Bei einer gegenüber der Phase des Eingangssignals verzögerten Phase des Ausgangssignals des spannungsgesteuerten Oszillators erzeugt der Phasendetektor ein Signal "High", H, im umgekehrten Fall einer Voreilung gegenüber der Phase des Ausgangssignals ein Signal "Low", L. In den Zeiten dazwischen, in denen kein Korrektursignal gebildet wird, befindet sich der Phasendetektor PD auf einem Mittelwert zwischen den Zuständen "High" und "Low" und es erfolgt keine Änderung am Eingang des VCO. Aus dem Diagramm nach Fig. 7 ist zu erkennen, daß ein Ausgangssignal des Phasendetektors PD in Form eines Signals H oder L nur durch den Vergleich der abfallenden Flanken der Sollschwingung und der Ausgangsschwingung des VCO gebildet wird und korrigierend auf den Eingang eines VCO wirkt.

Zum Zeitpunkt (1) eilt die Phase der Sollschwingung SOLL der Phase der Ausgangsschwingung VCOA des VCO voraus, d.h. am Ausgang des Phasendetektors PD erscheint ein Zustand H, der die nächste Zustandsänderung am Ausgang des VCO aufgrund einer hohen Verstärkung, der eine hohe Dämpfung entspricht, wesentlich beschleunigt. Zum nächsten Vergleichszeitraum (2) liegen die Phasenverhältnisse umgekehrt, d.h. die abfallende Flanke der Ausgangsschwingung VCOA des VCO eilt der abfallenden Flanke der Sollschwingung SOLL voraus, wobei der Phasenfehler sogar erheblich größer geworden ist. Aufgrund der nunmehr starken Verzögerung der nächsten Zustandsänderung des Ausgangssignals des VCO ändert sich zum nächsten Vergleichszeitpunkt (3) das Vorzeichen des Phasenfehlers wiederum bei gleichzeitig höherem Betrag des Fehlers. Auf diese Weise schaukelt sich das System auf und wird instabil.

Bei den vorstehenden einfachen Überlegungen Zum Diagramm nach Fig. 7 ist allerdings das reale physikalische Verhalten nicht ganz zutreffend berücksichtigt. Zwar wird der Phasenfehler aufgrund der hohen Verstärkung vom Vergleichszeitraum (1) nach (2) anwachsen, nicht jedoch vom Vergleichszeitraum (2) zum Vergleichszeitraum (3). Der Grund für dieses Verhalten liegt darin, daß der VCO keine negativen Frequenzen erzeugen und rückwärts arbeiten kann. Deshalb wird der VCO im schlimmsten Fall für die Dauer des Vergleichszeitraums (2) seine Schwingungen unterbrechen und zum Beginn des Vergleichszeitraums (3) mit seinem normalen Betrieb wieder beginnen. Voraussetzung ist, daß die Kapazität C eines Schleifenfilters nach Fig. 3 groß genug gewählt wird, um die Spannung näherungsweise auf einem konstanten Niveau für diesen Zeitraum zu halten. In diesem Fall läßt sich eine durch die gestrichelt gezeichnete Linie angedeutete Schwingung erhalten, bei der der Phasenfehler verschwindet. Wahrend also bei negativen Phasenfehlern eine hohe Dämpfung wünschenswert ist, darf die Dämpfung bei positiven Phasenfehlern nicht zu groß werden.

Fig. 8 dient zur Erläuterung der für die Schaltgröße s abzuleitenden Strategie für einen zeitdiskreten Phasenregelkreis nach Fig. 5. In Fig. 8a sind die zeitlichen Verläufe der Amplituden der Sollfunktion SOLL und der Ausgangsfunktion VCOA des spannungsgesteuerten Oszillators aufgetragen. Dazu erläutert Fig. 8b den zeitlichen Verlauf des Phasenfehlers φd, wenn in einem Ausführungsbeispiel nach Fig. 5 zwischen den Filtercharakteristiken des Filters F1 und F2 umgeschaltet wird. Bei negativen Phasenfehlern existiert eine große Dämpfung des Filters F2, während bei positiven Phasenfehlern die Dämpfung F2 gering ist oder aber verschwindet. Der zeitliche Verlauf der Amplituden nach Fig. 8a läßt erkennen, daß der Phasenfehler φd schnell abnimmt und das System stabil ist. Dabei ist in den Diagrammen nach Fig. 8 zugelassen, daß das Regelungssystem als getastetes System in einem Zweier-Schwingungsmodus arbeitet, nichtlinear und zeitdiskret ist, Totzeiten enthält und der Phasenfehler mit höchstmöglicher Frequenz, d.h. der halben Abtastfrequenz schwingt. Selbst unter diesen extremen Betriebsbedingungen bleibt das System stabil.

Die gleichen Diagramme wie Fig. 6 bis Fig. 8 erhält man, wenn statt zweier Schleifenfilter F1 und F2 und einer Eingangsschaltung des VCO ein Schleifenfilter F und zwei umschaltbare Eingangsschaltungen des VCO vorhanden sind.

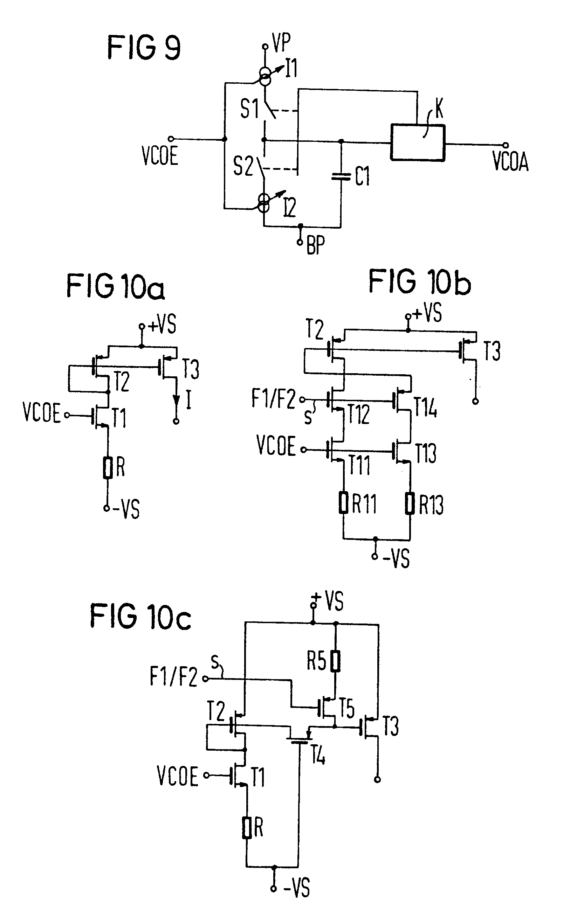

Fig. 9 gibt ein Prizipschaltbild eines spannungsgesteuerten Oszillators (VCO) an. Dieser enthält als wesentliche Elemente einen Ladekondensator C1, der von umschaltbaren spannungsgesteuerten Stromquellen I1 und I2 geladen und entladen wird. Zur Steuerung der Schalter S1 und S2 dient ein Kontrollnetzwerk K. Im einzelnen ist der Eingang VCOE des spannungsgesteuerten Oszillators, an dem im Betriebsfall eine Spannung anliegt, mit den beiden Stromquellen I1 und I2 verbunden, um ihren Strom zu steuern. Ein Pol der Stromquelle I1 liegt an einer mit einem Versorgungspotential beaufschlagten Klemme VP, der andere Pol an einem Kontakt des in Serie liegenden Schalters S1. Der andere Kontakt des Schalters S1 ist mit einem Kontakt des in Serie liegenden Schalters S2 verbunden, dessen anderer Kontakt mit einem Pol der wiederum in Serie liegenden Stromquelle I2 , deren anderer Pol an einer ein Bezugspotential führenden Klemme BP liegt.

Der Ladekondensator C1 ist zwischen dem Verbindungspunkt der beiden Schalter S1 und S2 und der das Bezugspotential führenden Klemme BP angeschlossen. Der Verbindungspunkt der beiden Schalter S1 und S2 ist weiterhin auf den Eingang eines in Fig. 9 als Block gezeichneten Kontrollnetzwerks K geführt. Ein Ausgang dieses Kontrollnetzwerks K ist mit dem Ausgang VCOA des spannungsgesteuerten Oszillators verbunden, der andere steuert die Schaltstellungen der Schalter S1 und S2. In Fig. 9 sind beide Schalter geöffnet gezeichnet und die Schaltung ist nicht betriebsbereit.

Durch Schließen eines der Schalter S1 oder S2 wird der Kondensator C1 über die Stromquelle I1 entweder geladen oder über die Stromquelle I2 entladen. Aufgabe des Kontrollnetzwerkes K ist es daher, die Schalter S1 und S2 antivalent ein- bzw. auszuschalten. Vorzugweise enthält daher das Kontrollnetzwerk K einen Schmitt-Trigger mit Invertern, dessen bzw. deren Ausgänge mit den Steuerelementen der Schalter S1 und S2 und der Ausgangsklemme VCOA verbunden sind.

Die Amplitude der am Eingang VCOE liegenden Spannung bestimmt den Strom durch die Stromquellen I1 und I2 und damit das Auf- und Entladeverhalten des Kondensators C1 bzw.die am Ausgang VCOA mit Hilfe des Kontrollnetzwerks K erzeugte Schwingung. So erhält man am Ausgang VCOA des VCO bei einer an seinem Eingang VCOE liegenden höheren Spannung aufgrund der schnelleren Aufladung des Kondensators C1 eine schnellere Umschaltung des Ausgangszustandes. Dieser Fall entspricht dem Zeitpunkt (1) nach Fig. 7. Umgekehrt bedeutet eine niedrigere Spannung am Eingang VCOE des VCO während der Entladephase des Kondensators C1 eine längere Entladezeit und damit eine verzögerte Zustandsänderung des Ausgangs VCOA des VCO.

Fig. 10 zeigt Ausführungsbeispiele für Eingangsschaltungen integrierfähiger spannungsgesteuerter Oszillatoren. Zum Vergleich der in Fig. 10 b und 10c ausgeführten erfindungsgemäßen Beispiele dient die an sich bekannte Teilschaltung nach Fig. 10a zur Erläuterung einer spannungsgesteuerten Stromquelle. Die aktiven Elemente in Fig. 10 sind MOS-Transistoren in CMOS-Technik. Den Schaltungseingang bildet in Fig. 10a die Klemme VCOE, die mit dem Gate eines n-Kanal-Transistors T1 verbunden ist. Der Sourceanschluß von T1 liegt über einen Widerstand R an der negativen Versorgungsspannung -VS, die das Bezugspotential darstellt. Der Drainanschluß von T1 ist mit dem Drainanschluß und dem Gate eines p-Kanal-Transistors T2 verbunden, dessen Source am positiven Versorgungsspannungspotential +VS liegt. Parallel zum Transistor T2 liegt der Transistor T3 ebenfalls mit seiner Source am positiven Versorgungsspannungspotential +VS und mit seinem Gate am Gate des Transistors T2 Der Drainanschluß führt über eine nicht näher bezeichnete Klemme zu den signalmäßig nachfolgenden Schaltungsteilen.

Bei einer im Vergleich zu seiner Sourcespannung ausreichend hohen Gatespannung des Transistors T1 gelangt die-. ser ebenso wie der als Diode geschaltete Transistor T2 in den leitenden Zustand. Durch die Source-Drain-Strecken der Transistoren T1 und T2 sowie den Widerstand R fließt dann ein von der Gatespannung des Transistors T1 abhängiger Strom. Mit dem sich am Gate des Transistors T2 und damit des Transistors T3 einstellenden Potential wird dem Transistor T3 ein Strom eingeprägt. Die aus den Transistoren T2 und T3 bestehende Stromspiegel-Anordnung wird in der integrierten Technik dazu benutzt, Übersetzungsverhältnisse zwischen den Strömen in dem als Diode geschalteten Transistor und dem eigentlichen Stromquellentransistor zu realisieren. In Fig. 10a wirkt sich eine Spannungsänderung am Eingang der Teilschaltung direkt auf den durch den Widerstand R fließenden Strom und damit auf das Potential am Gate des Transistors T3 aus, so daß sich der Ausgangsstrom I ändert. Man erhält so eine Transformation der Eingangsspannung in einen Referenzstrom, der für die Höhe des Lade- bzw. Entladestroms eines Kondensators eines VCO nach Fig. 9 verantwortlich ist.

Entsprechend der anhand von Fig. 10a geschilderten Anordnung zeigt Fig. 10b eine Teilschaltungsanordnung, mit der sich zwei verschiedene Eingangsschaltungen eines VCO einer erfindungsgemäßen PLL-Schaltung bei nur einem einzigen Schleifenfilter realisieren lassen. Die Schaltung des Transistors T2 bezüglich des Versorgungsspannungspotentials +VS und des Transistors T3 bleibt unverändert erhalten, während gegenüber der Fig. 10a der Verbindungspunkt des Drainanschlusses und des Gates des Transistors T2 nunmehr mit zwei parallelen Kreisen verbunden ist, die gegen das Bezugspotential -VS geschaltet sind. Jeder der parallelen Kreise enthält entsprechend zu Fig. 10a einen n-Kanal-Transistor T11 bzw. T13, dessen Gates miteinander und mit der Eingangsklemme VCOE verbunden sind. Die Sourceanschlüsse der Transistoren T11 bzw. T13 sind jeweils über einen Widerstand R11 bzw. R13 miteinander und mit der Klemme -VS für das Bezugspo-tential verbunden. In Reihe zur Drain-Source-Strecke des Transistors T11 liegt die Drain-Source-Strecke eines n-Kanal-Transistors T12, der mit seinem Drain am Verbindungspunkt von Gate und Drain des Transistors T2 und mit seiner Source am Drain des Transistors T11 angeschlossen ist. Entsprechend liegt in Reihe zur Drain-Source-Strecke des Transistors T13 die Source-Drain-Strecke eines p-Kanal-Transistors T14, dessen Source am Verbindungspunkt von Gate und Drain des Transistors T2 und dessen Drain am Drain des Transistors T13 liegt. Die Gates der Transistoren T12 und T14 sind miteinander und mit einer Klemme F1/F2 verbunden.

Die Transistoren T12 und T14 wirken als Schalter, bei dem abhängig von an der Klemme F1/F2 liegenden Signal s antivalent jeweils ein Transistor durchgeschaltet ist, während der andere sperrt. Mit einem Eingangssignal für den VCO an der Klemme VCOE fließt damit durch den als Diode geschalteten Transistor T2 und jeweils einen der durch die Ausgangskreise der Transistoren T11, T12 in Verbidung mit dem Widerstand R11 bzw. durch die Ausgangskreise der Transistoren T13, T14 in Verbindung mit dem Widerstand R13 gebildeten Zweig ein Strom, der in den Transistor T3 gespiegelt wird und zur Auf- bzw. Entladung eines Kondensators verwendet wird. Abhängig von der Größe des Widerstandes R11 bzw. R13 und der Spannung an der Klemme VCOE ist der in den beiden Kreisen fließende Strom unterschiedlich groß.

Entsprechend einer erfindungsgemäßen PLL-Schaltung nach Fig. 5 läßt sich in Fig. 10b beispielsweise für negative Phasenfehler eine große Dämpfung und durch Umschaltung zwischen den Transistoren T12 und T14 für positive Phasenfehler eine nur geringe Dämpfung erzielen. Auf diese Weise läßt sich die Umschaltung des VCO verlangsamen oder sogar stoppen.

Während nach Fig. 10b der Eingang des VCO zwischen zwei Stromquellen mit verschiedenen Strömen hin- und hergeschaltet wird, zeigt Fig. 10c ein Ausführungsbeispiel für nur ein einziges erforderliches Schleifenfilter bei einer Eingangsschaltung des VCO mit einer einzigen Stromquelle, der mit Hilfe eines an der Klemme F1/F2 liegenden Signals s eine zweite Stromcharakteristik zur Erzielung einer unterschiedlichen Gesamtstromcharakteristik zugeschaltet werden kann.

Ein erster Zweig, der die in Reihe geschalteten Transistoren T2, T1 und den Widerstand R enthält entspricht dem die gleichen Elemente enthaltenden Kreis nach Fig. 10a. Auch ein Transistor T3, der mit seiner Source am positiven Versorgungsspannungspotential +VS und seinem Drain an einer nicht näher bezeichneten Klemme für den Anschluß der nachfolgenden Schaltung liegt, ist aus Fig. 10a zu entnehmen. Zwischen dem Gate des Transistors T2 und dem Gate des Transistors T3 liegt bei Fig. 10c die Drain-Source-Strecke eines p-Kanal-Transistors T4, dessen Gate mit der Klemme -VS für das Bezugspotential und einem Anschluß des Widerstandes R verbunden ist. Während der Drainanschluß von T4 an das Gate von T2 angeschlossen ist, ist der Sourceanschluß von T4 mit dem Gate von T3 und dem Drain eines weiteren p-Kanal-Transistors T5 verbunden. Der Sourceanschluß von T5 liegt über einen Widerstand R5 an der Klemme +VS für das Versorgungsspannungspotential und das Gate von T5 an der Klemme F1/F2. In diesem Beispiel wirkt der Transistor T4 als Widerstand und der Transistor T5 als Schalter.

Bei positiven Phasenfehlern des Phasendetektors PD ist der Transistor T5 nicht leitend und die beiden Transistoren T2 und T3 in Verbindung mit dem Transistor T1 und dem Widerstand R arbeiten wie in Fig. 10a als Stromspiegel für den durch T1, T2 und R fließenden Strom. Bei einem negativen Phasenfehler gelangt der Transistor T5 in den leitenden Zustand und das Gatepotential des Transistors T3 wird angehoben. Gleichzeitig wird über T4 das Gatepotential des Transistors T2 angehoben, so daß der Strom durch den Stromspiegel verringert oder sogar abgeschaltet werden kann.

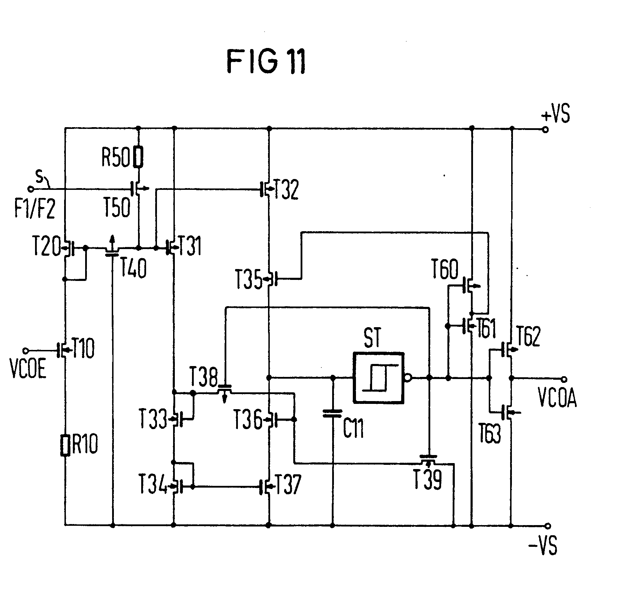

Fig. 11 zeigt ein Ausführungsbeispiel einer erfindungsgemäßen Schaltung eines VCO mit einer umschaltbaren spannungsgesteuerten Referenzstromquelle nach Fig. 10c, für die nur ein einziges Schleifenfilter, z. B. ein Integrier- oder Halteglied C notwendig ist. Darin entsprechen die Elemente T10, T20, T40, T50, R10, R50 in dieser Reihenfolge den Elementen T1, T2, T4, T5, R, R5. Der Transistor T3 ist in Fig. 11 doppelt ausgelegt durch die Transistoren T31 und T32 , die mit ihren Gates entsprechend dem Transistor T3 angeschlossen sind. Ein Anschluß des Ausgangskreises von T31 liegt an der Klemme +VS der positiven Versorgungsspannung, der andere in Reihe zu den Ausgangskreisen zweier als Dioden beschalteter Transistoren T33 und T34, von denen die Source von T34 mit der Klemme -VS des Bezugspotentials verbunden ist. Der Ausgangskreis des Transistors T32 ist mit einem Anschluß an der Klemme +VS angeschlossen und liegt mit seinem anderen Anschluß in Reihe zu den Ausgangskreisen der Transistoren T35, T36 und T37, wobei ein Anschluß des Ausgangskreises von T37 mit der Klemme -VS verbunden ist.

Der Gateanschluß des Transistors T33 ist mit dem Drainanschluß desselben Transistors und über die Ausgangskreise der Transistoren T38 und T39 mit der Klemme -VS verbunden. Das Gate des Transistors T36 liegt am Verbindungspunkt der Ausgangskreise der Transistoren T38 und T39. Das Gate des Transistors T34 ist mit dem Drain dieses Transistors und mit dem Gate des Transistors T37 verbunden.

Eine die Funktion des VCO bestimmende Kapazität C11 liegt mit einem Anschluß an der Klemme -VS und mit dem anderen Anschluß am Verbindungspunkt der Ausgangskreise der Transistoren T35 und T36 sowie am Eingang eines Schmitt-Triggers ST mit invertierendem Ausgang. Der Ausgang des invertierenden Schmitt-Triggers ST steuert die Gates der Transistoren T38 und T39 sowie die Gates der Transistoren T40 und T41 bzw. T42 und T43. Die Ausgangskreise der Transistoren T40 und T41 bzw. T42 und T43 liegen jeweils in Reihe und zwischen den Klemmen +VS und -VS der Versorgungsspannung. T40 zu T41 und T42 zu T43 sind komplementär und bilden jeweils einen Inverter. Während der Verbindungspunkt der Ausgangskreise der Transistoren T40 und T41 mit dem Gate des Transistors T35 verbunden ist, stellt der Verbindungspunkt der Ausgangskreise der Transistoren T42 und T43 den Ausgang der Schaltung dar, der mit der Klemme VCOA des spannungsgesteuerten Oszillators verbunden ist.

Über den durch die Transistoren T31 bzw. T32 fließenden Strom wird die Kapazität C11 abwechselnd ent- bzw. geladen. Dazu werden vom Ausgang des invertierenden Schmitt-Triggers ST die Transistoren T38 und T39 beim Entladen der Kapazität C11 durchgeschaltet, während über den Inverter aus den Transistoren T40 und T41 und das Gate des Transistors T35 dessen Ausgangskreis gesperrt wird. Dann arbeiten die Iransistoren T33 und T36 sowie T34 und T37 als kaskadierte Stromspiegel, die mit dem durch den Ausgangskreis des Transistors T31 fließenden Strom entsprechend den zugehörigen Übersetzungsverhältnissen den kondensator C11 entladen. In diesem Zustand entspricht das Potential der Ausgangsklemme VCOA des spannungsgesteuerten Oszillators dem Gatepotential des Transistors T35.

Beim Umschalten des invertierenden Schmitt-Triggers ST sobald die Kapazität C11 genügend entladen ist, sperren die Transistoren T38 und T39, während der Transistor T35 in den leitenden Zustand gelangt. Entsprechend wird das Potential der Ausgangsklemme VCOA umgeschaltet, bis die Kapazität C11 soweit aufgeladen ist, daß der invertierende Schmitt-Trigger ST abermals umschaltet. In jedem Schaltzustand des VCO kann mit Hilfe des an der Eingangsklemme F1/F2 liegenden Signals s der Stroh durch die Transistoren T31 bzw. T32 und damit die Ent- bzw. Aufladezeit der Kapazität C11 beeinflußt werden. Erfindungsgemäß läßt sich dann die Umschaltung des Ausgangszustandes des VCO für jeden Schwingungszustand verzögern oder sogar verhindern.

Der invertierende Schmitt-Trigger ST nach Fig. 11 läßt sich mit an sich bekannten Mitteln schaltungstechnisch realisieren. In derselben Figur bilden die Transistoren T20, T40, T50, T31, T32, T35, T38, T60 und T62 Transistoren vom p-Kanal-Typ, die Transistoren T10, T33, T34, T36, T37, T39, T61 und T63 Transistoren vom n-Kanal-Typ.

## Patentansprüche

1. Dynamisches Regelungssystem, dessen Zustand durch seinen Zustandsvektor gegeben ist, mit mindestens einem Regelkreis, der eine Erfassungs- oder Meßeinrichtung (1; T), eine Vergleichseinrichtung (2; PD), eine Korrektureinrichtung (3,6; F1, F2, S) und eine Stelleinrichtung (4; I1, I2, S1, S2) mit Regelstrecke (5; VCO) enthält, in denen eine Regelgröße (x; ωx) erfaßt und mit einer Sollgröße (w; φw) zur Bildung einer Regeldifferenz (d; φd) verglichen wird, aus der ihrerseits im Sinne einer zu erzielenden Charakteristik des Regelkreises mit Hilfe der Korrektur- (3,6; S, F1, F2, S) und Stelleinrichtung (4; I1, I2, S1, S2) eine Stellgröße (y) abgeleitet wird, die auf die Regelstrecke (5; VCO) mit der Regelgröße (x; ωx) als Ausgangsgröße wirkt, wobei jeder Regelkreis mit anderen Regelkreisen und/oder anderen Größen des dynamischen Regelungssystems verkoppelt sein kann und in wenigstens einem Regelkreis die Korrektureinrichtung (6; F1, F2, S) und/oder die Stelleinrichtung (4; I1, I2, S1, S2) mit Regelstrecke (5; VCO) mindestens zwei durch einen Schalter (S) umschaltbare Funktionsgruppen (61, 62, 6i; F1, F2) mit unterschiedlichen Charaktieristiken enthält, von denen wenigstens eine nicht dauernd zur Ableitung der Stellgröße (x) im Signalweg der Regeldifferenz (d; φd) liegt, wobei der Schalter (S) zur Umschaltung der Funktionsgruppen (61, 62, 6i; F1, F2) in Abhängigkeit von vorherbestimmten Kriterien bei jeder momentanen den Kriterien zugeordneten Änderung des Zustandsvektors umschaltet,
**dadurch gekennzeichnet,**
daß eine Funktionsgruppe (F1) eine ungedämpfte Charakteristik und eine andere Funktionsgruppe (F2) eine gedämpfte Charakteristik hat und der Schalter (S) zwischen den beiden Funktionsgruppen (F1, F2) bei einem Vorzeichenwechsel der Regeldifferenz umschaltet.

2. Dynamisches Regelungssystem nach Anspruch 1, **dadurch gekennzeichnet**, daß die Funktionsgruppen (61, 62, 6i; F1, F2) mit unterschiedlichen Charakteristiken parallel angeordnet sind.

3. Dynamisches Regelungssystem noch Anspruch 1 oder 2, **dadurch gekennzeichnet**, daß der Regelkreis einen Schalter (S) zur Umschaltung der Funktionsgruppen (61, 62, 6i; F1, F2) mit unterschiedlichen Charakteristlken enthält.

4. Dynamisches Regelungssystem nach Anspruch 1 bis 3, **dadurch gekennzeichnet**, daß eine der Funktionsgruppen (61, 62, 6i; F1, F2) mit unterschiedlichen Charakteristiken zur Ableitung der Stellgröße (y) im Signalweg der Regeldifferenz (d; φd) liegt.

5. Dynamisches Regelungssystem nach Anspruch 1 bis 3, **dadurch gekennzeichnet**, daß mindestens zwei der Funktionsgruppen (61, 62, 6i; F1, F2) mit unterschiedlichen Charakteristiken zur Ableitung der Stellgröße (y) parallel im Signalweg der Regeldifferenz (d; φd) liegen.

6. Dynamisches Regelungssystem nach Anspruch 1 bis 5, **dadurch gekennzeichnet**, daß der Schalter (S) abhängig vorn Zustand der Regelstrecke (4, 5; VCO) und/oder der Vergleichseinrichtung (2; PD) und/oder der Erfassungs- oder Meßeinrichtung (1; T) und/oder von Systemparametern des Regelungssystems und/ oder von Störgrößen (z) und/oder der Sollgröße (w) und/oder zeitabhängig umschaltbar ist.

7. Dynamisches Regelungssystem nach Anspruch 1 bis 6, **dadurch gekennzeichnet**, daß der Schalter (S) diskret oder kontinuierlich umschaltbar ist.

8. Dynamisches Regelungssystem nach Anspruch 1 bis 7, **dadurch gekennzeichnet**, daß die Funktionsgruppen (61, 62, 6i; F1, F2) mit unterschiedlichen Charakteristiken Filter (F1, F2) mit verschiedenen Filtercharakteristiken sind.

9. Dynamisches Regelungssystem nach Anspruch 1 bis 7, **dadurch gekennzeichnet**, daß die Funktionsgruppen (61, 62, 6i; F1, F2) mit unterschiedlichen Charakteristiken Eingangsschaltungen der Stelleinrichtung (4; I1, I2, S1, S2) mit Regelstrecke (5;VCO) sind.

10. Dynamisches Regelungssystem nach Anspruch 1 bis 9, **dadurch gekennzeichnet**, daß die Funktionsgruppen (61, 62, 6i; F1, F2) mit unterschiedlichen Charakteristiken gebildet sind durch eine Funktionsgruppe einer Charakteristik, der mit Hilfe eines Schalters (S) mindestens eine Teilcharakteristik zur Erzielung einer unterschiedlichen Gesamtcharakteristik zuschaltbar ist.

11. Dynamisches Regelungssystem nach Anspruch 1 bis 10, **gekennzeichnet** durch die Ausführung als Digitalsystem.

12. Dynamisches Regelungssystem nach Anspruch 1 bis 10, **gekennzeichnet** durch die Ausführung als Analogsystem.

13. Dynamisches Regelungssystem nach Anspruch 1 bis 12, **gekennzeichnet** durch Ausbildung als Phase-Locked-Loop-Schaltung (PLL), bei dem als Vergleichseinrichtung (2) ein Phasendetektor (PD), als Korrektureinrichtung (6) wenigstens ein Filter (F1, F2), als Stelleinrichtung mit Regelstrecke (4, 5) ein spannungsgesteuerter Oszillator (VCO) mit einer Eingangsschaltung und einer Schwingung ( ωx) als Regelgröße (x) und als Meßeinrichtung (1) ein Frequenzmesser (T) realisiert sind.

14. Dynamisches Regelungssystem nach Anspruch 13, **dadurch gekennzeichnet**, daß das oder die Filter (F1, F2;C) Tiefpaßcharakteristik besitzen.

15. Dynamisches Regelungssystem nach Anspruch 13 bis 14, **dadurch gekennzeichnet**, daß die Tiefpaßcharakteristik der Filter (F1, F2) mit Hilfe von Integrier- oder Haltegliedern (C) realisiert ist.

16. Dynamisches Regelungssystem nach Anspruch 13 bis 15, **dadurch gekennzeichnet**, daß als Korrektureinrichtung (F1, F2, S) zwei parallele Filter (F1, F2) mit unterschiedlichen Filtercharakteristiken realisiert und mit Hilfe eines Schalters (S) umschaltbar sind.

17. Dynamisches Regelungssystem nach Anspruch 13 bis 15, **dadurch gekennzeichnet**, daß als Korrektureinrichtung (F1, F2, S) ein Filter mit einer Filtercharakteristik realisiert und mit Hilfe eines Schalters (S) auf eine andere Filtercharakteristik umschaltbar ist.

18. Dynamisches Regelungssystem nach Anspruch 13 bis 15, **dadurch gekennzeichnet**, daß als Filter ein Integrier- oder Halteglied (C) vorgesehen ist, und als Eingangsschaltung des spannunosgesteuerten Oszillators (VCO) zwei spannungsgesteuerte Referenzstromquellen (T2, T3, T11 bis T14, R11, R13) realisiert und mit Hilfe eines Schalters (S;T12,T14) umschaltbar sind.

19. Dynamisches Regelungssystem nach Anspruch 13 bis 15, **dadurch gekennzeichnet**, daß als Filter ein Integrier- oder Halteglied (C) vorgesehen ist und als Eingangsschaltung des spannungsgesteuerten Oszillators (VCO) eine spannungsgesteuerte Referenzstromquelle (T1 bis T5, R, R5; T10, T20, T31, T32, T40, T50, R10, R50) mit einem Referenzstrom realisiert und mit Hilfe eines Schalters (5; T5;T50) auf einen anderen Referenzstrom umschaltbar ist.

20. Dynamisches Regelungssystem nach Anspruch 13 bis 19, **dadurch gekennzeichnet**, daß der Schalter (S) abhängig vom Zustand des Phasendetektors (PD) umschaltbar ist.

21. Dynamisches Regelungssystem nach Anspruch 13 bis 20, **dadurch gekennzeichnet**, daß der Schalter (S) abhängig vom Vorzeichen der vom Phasendetektor (PD) zu bildenden Regeldifferenz ( φd ) umschaltbar ist.

22. Dynamisches Regelungssystem nach Anspruch 13 bis 21, **dadurch gekennzeichnet**, daß der spannungsgesteuerte Oszillator (VCO) eine von schaltbaren Stromquellen (I1, I2; T10, T20, T31, T32, R10) lad- und entladbare Kapazität (C1; C11) und ein von der Kapazität (C1; C11) steuerbares Kontrollnetzwerk (K) enthält, das mit Stromquellenschaltern (S1, S2; T35, T38, T39) zur Umschaltung der Stromquellen (I1, I2; T10, T20, T31, T32, R10) und mit dem Ausgang (VCOA) des spannungsgesteuerten Oszillators (VCO) verbunden ist.

23. Dynamisches Regelungssystem nach Anspruch 13 bis 22, **dadurch gekennzeichnet**, daß das Kontrollnetzwerk (K) einen den Ausgangszustand des spannungsgesteuerten Oszillators (VCO) bestimmenden Schmitt-Trigger (ST) und Inverterstufen (T60 bis T63) enthält.

24. Dynamisches Regelungssystem nach Anspruch 13 bis 23, **dadurch gekennzeichnet**, daß die Stromquellenschalter (S1, S2; T35, T38, T39) mit antivalenten Steuerausgängen des Kontrollnetzwerks (K) verbunden sind.

25. Dynamisches Regelungssystem nach Anspruch 13 bis 24, **dadurch gekennzeichnet**, daß die spannungsgesteuerte Referenzstromquelle von einem Ausgangstransistor (T3) eines ersten Typs gebildet wird,
dessen Ausgangskreis einen Referenzstrom führt und dessen Eingangskreis vom Eingangskreis eines mit diesem Transistor (T3) einen Stromspiegel bildenden, als Diode geschalteten Transistor (T2) vom gleichen Typ gesteuert wird,
in dessen Ausgangskreis zwei parallele Zweige mit je zwei, mit je einem Widerstand (R11, R13) in Serie geschalteten Ausgangskreisen zweier Transistoren (T11 bis T14) liegen, wobei die Transistoren (T11, T12) des ersten Zweiges vom zweiten Typ und die Transistoren (T13 T14) des zweiten Zweiges vom ersten und zweiten Typ sind und
in beiden Zweigen je zwei Transistoren, einerseits zwei (T11, T13) vom zweiten Typ und andererseits zwei (T12, T14), vom ersten und zweiten Typ, gleiche, die Eingänge (VCOE, F1/F2) der spannungsgesteuerten Referenzstromquelle bildende Eingangskreise besitzen und
die Widerstände (R11, R13) verschieden groß sind.

26. Dynamisches Regelungssystem nach Anspruch 13 bis 24, **dadurch gekennzeichnet**, daß die spannungsgesteuerte Referenzstromquelle von einem Ausgangstransistor (T3, T31, T32) des ersten Typs gebildet wird, dessen Ausgangskreis einen Referenzstrom führt und dessen einer Anschluß des Ausgangskreises mit einem Anschluß des Ausgangskreises eines mit diesem Transistor (T3, T31, T32) einen Stromspiegel bildenden, als Diode geschalteten Transistor (T2, T20) vom gleichen Typ verbunden ist,
daß zwischen den Eingangskreisen der Transistoren (T2, T3, T20, T31, T32) ein Ausgangskreis eines weiteren Transistors (T4, T40) vom gleichen Typ und zwischen den Verbindungspunkten des Ausgangskreises des weiteren Transistors (T4, T40) und des Eingangskreises des Ausgangstransistors (T3, T31, T32) einerseits und der Ausgangskreise des Ausgangstransistors (T3, T31, T32) und des als Diode geschalteten Transistors (T2, T20) andererseits der Ausgangskreis eines Schalttransistors (T5, T50) vom ersten Typ in Serie zu einem Widerstand (R5, R50) liegt,
daß in Serie zum Ausgangskreis des als Diode geschalteten Transistors (T2, T20) der Ausgangskreis eines Eingangstransistors (T1, T10) vom zweiten Typ und ein Widerstand (R, R10) liegt, dessen freier Anschluß mit dem Eingangskreis des weiteren Transistors (T4, T40) verbunden ist und
daß die Eingänge des Eingangstransitors (T1, T10) und des Schalttransistors (T5, T50) die Eingänge (VCOE, F1/F2) der spannungsgesteuerten Referenzstromquelle bilden.

27. Dynamisches Regelungssystem nach Anspruch 13 bis 26, **dadurch gekennzeichnet**, daß die spannungsgesteuerte Referenzstromquelle zwei parallele Ausgangstransistoren (T31, T32) besitzt, von denen einer (T32) über einen elektronischen Schalter (S1;T35) mit einem Anschluß einer Kapazität (C1, C11) und dem Ausgangskreis eines über einen weiteren elektronischen Schalter (S2;T38, T39) steuerbaren ersten Stromspiegeltransistor (T36) verbunden ist, dem der Ausgangskreis eines zweiten Stromspiegeltransistors (T37) in Serie geschaltet ist und denen je ein als Diode geschalteter Transistor (T33, T34) zugeordnet ist, deren Ausgangskreise in Serie und in Serie zum Ausgangskreis des anderen Ausgangstransistors (T31) der spannungsgesteuerten Referenzstromquelle liegen.

28. Dynamisches Regelungssystem nach Anspruch 13 bis 27, **gekennzeichnet** durch die Ausführung als Digitalsystem.

29. Dynamisches Regelungssystem nach Anspruch 13 bis 27, **gekennzeichnet** durch die Ausführung als Analogsystem.

30. Verfahren zum Betreiben eines dynamischen Regelungssystems nach Anspruch 1 bis 12, **dadurch gekennzeichnet**, daß der Schalter (S) abhängig vom Zustand der Regelstrecke (4, 5; VCO) und/oder von Systemparametern des Regelungssystems und/oder der Vergleichseinrichtung (2; PD) und/oder der Erfassungs- oder Meßeinrichtung (1; T) und/oder von Störgrößen (z) und/oder der Sollgröße (b) und/oder zeitabhängig umgeschaltet wird.

31. Verfahren nach Anspruch 30 zum Betreiben eines dynamischen Regelungssystems nach Anspruch 1 bis 12, **dadurch gekennzeichnet**, daß der Schalter (S) diskret oder kontinuierlich umgeschaltet wird.

32. Verfahren zum Betreiben eines dynamischen Regelungssystems nach Anspruch 13, bis 29, **dadurch gekennzeichnet**, daß der Schalter (S) abhängig vom Zustand des Phasendetektors (PD), insbesondere abhängig vom Vorzeichen der vom Phasendetektor (PD) zu bildenden Regeldifferenz ( φd) umgeschaltet wird.

33. Verfahren nach Anspruch 32 zum Betreiben eines dynamischen Regelungssystems nach Anspruch 13 bis 29, **dadurch gekennzeichnet**, daß die Stromquellenschalter (S1, S2; T35, T38, T39) zur Ladung und Entladung der Kapazität (C1;C11) des spannungsgesteuerten Oszillators (VCO) von antivalenten Steuerausgängen des Kontrollnetzwerkes (K; ST) umgeschaltet werden.

## Claims

1. Dynamic control system whose state is given by its state vector, having at least one control loop which contains a detection or measurement device (1; T), a comparator device (2; PD), a correction device (3, 6; F1, F2, S) and an actuating device (4; I1, I2, S1, S2) having a control path (5; VCO) in which a control variable (x; ωx) is detected and is compared with a required value (w, φw) in order to form a control difference (d; φd) from which, for its part, a manipulated variable (y) is derived in the sense of a characteristic which is to be achieved of the control loop, with the aid of the correction (3, 6; S, F1, F2, S) and the actuating device (4; I1, I2, S1, S2), which manipulated variable (y) acts on the control path (5; VCO) with the control variable (x; ωx) as the output variable, it being possible to couple each control loop to other control loops and/or to other variables of the dynamic control system and, in at least one control loop, the correction device (6; F1, F2, S) and/or the actuating device (4; I1, I2, S1, S2) with the control path (5; VCO) containing at least two functional groups (61, 62, 6i, F1, F2) which can be switched over by means of a switch (S) and have different characteristics, and of which functional groups at least one is temporarily located in the signal path of the control difference (d; φd) in order to derive the manipulated variable (x), the switch (S) switching over in order to switch over the functional groups (61, 62, 6i; F1, F2) as a function of predetermined criteria for each instantaneous change, associated with the criteria, of the state vector, characterized in that one functional group (F1) has an undamped characteristic and another functional group (F2) has a damped characteristic, and the switch (S) switches over between the two functional groups (F1, F2) when a change in the mathematical sign of the control difference occurs.

2. Dynamic control system according to Claim 1, characterized in that the functional groups (61, 62, 6i; F1, F2) having different characteristics are arranged in parallel.

3. Dynamic control system according to Claim 1 or 2, characterized in that the control loop contains a switch (S) for switching over the functional groups (61, 62, 6i; F1, F2) having different characteristics.

4. Dynamic control system according to Claims 1 to 3, characterized in that one of the functional groups (61, 62, 6i; F1, F2) having different characteristics is located in the signal path of the control difference (d; φd), in order to derive the manipulated variable (y).

5. Dynamic control system according to Claims 1 to 3, characterized in that at least two of the functional groups (61, 62, 6i; F1, F2) having different characteristics are located in parallel in the signal path of the control difference (d; φd), in order to derive the manipulated variable (y).

6. Dynamic control system according to Claims 1 to 5, characterized in that the switch (S) can be switched over as a function of the state of the control path (4, 5; VCO) and/or of the comparator device (2; PD) and/or of the detection or measurement device (1; T) and/or of system parameters of the control system and/or of disturbance variables (z) and/or of the required variable (w) and/or as a function of time.

7. Dynamic control system according to Claims 1 to 6, characterized in that the switch (S) can be switched over discretely or continuously.

8. Dynamic control system according to Claims 1 to 7, characterized in that the functional groups (61, 62, 6i; F1, F2) having different characteristics are filters (F1, F2) having different filter characteristics.

9. Dynamic control system according to Claims 1 to 7, characterized in that the functional groups (61, 62, 6i; F1, F2) having different characteristics are input circuits of the actuating device (4; I1, I2, S1, S2) with the control path (5; VCO).

10. Dynamic control system according to Claims 1 to 9, characterized in that the functional groups (61, 62, 6i; F1, F2) having different characteristics are formed by a functional group of one characteristic to which at least one characteristic element can be connected, with the aid of a switch (S), in order to achieve a different overall characteristic.

11. Dynamic control system according to Claims 1 to 10, characterized by being configured as a digital system.

12. Dynamic control system according to Claims 1 to 10, characterized by being configured as an analog system.

13. Dynamic control system according to Claims 1 to 12, characterized by being constructed as a phase-locked-loop circuit (PLL) in the case of which a phase detector (PD) is used as the comparator device (2), at least one filter (F1, F2) as the correction device (6), a voltage-controlled oscillator (VCO) is used as the actuating device with the control path (4, 5), which oscillator (VCO) has an input circuit and an oscillation (ωx) as the control variable (x), and a frequency meter (T) is used as the measurement device (1).

14. Dynamic control system according to Claim 13, characterized in that the filter or filters (F1, F2; C) has or have a low-pass characteristic.

15. Dynamic control system according to Claims 13 to 14, characterized in that the low-pass characteristic of the filters (F1, F2) is implemented with the aid of integrating or holding elements (C).

16. Dynamic control system according to Claims 13 to 15, characterized in that two parallel filters (F1, F2) having different filter characteristics are used as the correction device (F1, F2, S) and can be switched over with the aid of a switch (S).

17. Dynamic control system according to Claims 13 to 15, characterized in that a filter having a filter characteristic is used as the correction device (F1, F2, S) and is switched over to a different filter characteristic with the aid of a switch (S).

18. Dynamic control system according to Claims 13 to 15, characterized in that an integrating or holding element (C) is provided as the filter, and two voltage-controlled reference current sources (T2, T3, T11 to T14, R11, R13) are used as the input circuit of the voltage-controlled oscillator (VCO) and can be switched over with the aid of a switch (S; T12, T14).

19. Dynamic control system according to Claims 13 to 15, characterized in that an integrating or holding element (C) is provided as the filter and a voltage-controlled reference current source (T1 to T5, R, R5; T10, T20, T31, T32, T40, T50, R10, R50) having a reference current is used as the input circuit of the voltage-controlled oscillator (VCO), and can be switched over to a different reference current, with the aid of a switch (S; T5; T50).

20. Dynamic control system according to Claims 13 to 19, characterized in that the switch (S) can be switched over as a function of the state of the phase detector (PD).

21. Dynamic control system according to Claims 13 to 20, characterized in that the switch (S) can be switched over as a function of the mathematical sign of the control difference (φd) which is to be formed by the phase detector (PD).

22. Dynamic control system according to Claims 13 to 21, characterized in that the voltage-controlled oscillator (VCO) contains a capacitance (C1; C11), which can be charged and discharged by switchable current sources (I1, I2; T10, T20, T31, T32, R10), and a control network (K) which is controllable by the capacitance (C1; C11), is connected to current source switches (S1, S2; T35, T38, T39) in order to switch over the current sources (I1, I2; T10, T20, T31, T32, R10), and is connected to the output (VCOA) of the voltage-controlled oscillator (VCO).

23. Dynamic control system according to Claims 13 to 22, characterized in that the control network (K) contains a Schmitt trigger (ST), which determines the output state of the voltage-controlled oscillator (VCO), and invertor stages (T60 to T63).

24. Dynamic control system according to Claims 13 to 23, characterized in that the current source switches (S1, S2; T35, T38, T39) are connected to non-equivalent control outputs of the control network (K).

25. Dynamic control system according to Claims 13 to 24, characterized in that the voltage-controlled reference current source is formed by an output transistor (T3) of a first type, whose output circuit carries a reference current and whose input circuit is controlled by the input circuit of a transistor (T2) which forms a current mirror with this transistor (T3), is connected as a diode and is of the same type, in whose output circuit there are two parallel branches each having two output circuits, which are each connected in series with a resistor (R11, R13), of two transistors (T11 to T14), the transistors (T11, T12) of the first branch being of the second type and the transistors (T13, T14) of the second branch being of the first and second type, and two transistors in each of the two branches, on the one hand two (T11, T13) of the second type and on the other hand two (T12, T14) of the first and second type, having identical input circuits which form the inputs (VCOE, F1/F2) of the voltage-controlled reference current source, and the resistors (R11, R13) being of different size.

26. Dynamic control system according to Claims 13 to 24, characterized in that the voltage-controlled reference current source is formed by an output transistor (T3, T31, T32) of the first type whose output circuit carries a reference current, one of whose output circuit connections is connected to a connection of the output circuit of a transistor (T2, T20) which forms a current mirror with this transistor (T3, T31, T32), is connected as a diode and is of the same type, in that an output circuit of a further transistor (T4, T40) of the same type is connected between the input circuits of the transistors (T2, T3, T20, T31, T32), and the output circuit of a switching transistor (T5, T50) of the first type is connected in series with a resistor (R5, R50) between the junction points of the output circuit of the further transistor (T4, T40) and of the input circuit of the output transistor (T3, T31, T32) on the one hand, and the output circuits of the output transistor (T3, T31, T32) and of the transistor (T2, T20) which is connected as a diode on the other hand, in that the output circuit of an input transistor (T1, T10) of the second type and a resistor (R, R10) are connected in series with the output circuit of the transistor (T2, T20) which is connected as a diode, the free connection of said resistor (R, R10) being connected to the input circuit of the further transistor (T4, T40), and in that the inputs of the input transistor (T1, T10) and of the switching transistor (T5, T50) form the inputs (VCOE, F1/F2) of the voltage-controlled reference current source.

27. Dynamic control system according to Claims 13 to 26, characterized in that the voltage-controlled reference current source has two parallel output transistors (T31, T32), one of which (T32) is connected via an electronic switch (S1; T35) to a connection of a capacitance (C1, C11) and to the output circuit of a first current-mirror transistor (T36) which can be controlled via a further electronic switch (S2; T38, T39) and in series with which the output circuit of a second current-mirror transistor (T37) is connected and to which in each case one transistor (T33, T34) which is connected as a diode is allocated, whose output circuits are connected in series and in series with the output circuit of the other output transistor (T31) of the voltage-controlled reference current source.

28. Dynamic control system according to Claims 13 to 27, characterized by being configured as a digital system.

29. Dynamic control system according to Claims 13 to 27, characterized by being configured as an analog system.

30. Method for operating a dynamic control system according to Claims 1 to 12, characterized in that the switch (S) is switched over as a function of the state of the control path (4, 5; VCO) and/or of system parameters of the control system and/or of the comparator device (2; PD) and/or of the detection or measurement device (1; T) and/or of disturbance variables (z) and/or of the required variable (b) and/or as a function of time.

31. Method according to Claim 30 for operating a dynamic control system according to Claims 1 to 12, characterized in that the switch (S) is switched over discretely or continuously.

32. Method for operating a dynamic control system according to Claims 13 to 29, characterized in that the switch (S) is switched over as a function of the state of the phase detector (PD), preferably as a function of the mathematical sign of the control difference (φd) which is to be formed by the phase detector (PD).

33. Method according to Claim 32 for operating a dynamic control system according to Claims 13 to 29, characterized in that the current-source switches (S1, S2; T35, T38, T39) for charging and discharging the capacitance (C1; C11) of the voltage-controlled oscillator (VCO) are switched over by non-equivalent control outputs of the control network (K; ST).

## Revendications

1. Système de régulation dynamique, dont l'état est déterminé par son vecteur d'état, comportant au moins un circuit de réglage, qui comporte un dispositif de détection ou de mesure (1; T), un dispositif comparateur (2; PD), un dispositif de correction (3, 6; F1, F2, S) et un dispositif de réglage (4; I1, I2, S1, S2) à système asservi (5; VCO), dans lesquels une grandeur commandée (x; ωx) est détectée et est comparée à une grandeur de consigne (w; φw) pour la formation d'une différence de réglage (d; φd), à partir de laquelle est dérivée, pour sa part, dans le sens d'une caractéristique à obtenir du circuit de réglage, à l'aide du dispositif de correction (3; 6; S, F1, F2, S) et du dispositif de réglage (4; I1, I2, S1, S2), une grandeur de commande (y), qui agit sur le système asservi (5; VCO), avec la grandeur commandée (x; ωx), en tant que grandeur de sortie, du type dans lequel chaque circuit de réglage peut être couplé à d'autres circuits de réglage et/ou à d'autres grandeurs du système de régulation dynamique et, dans au moins un circuit de réglage, le dispositif de correction (6; F1, F2, S) et/ou le dispositif de réglage (4; I1, I2, S1, S2) à système asservi (5; VCO) comporte au moins deux groupes fonctionnels (61, 62, 6i; F1, F2), qui peuvent être commutés au moyen d'un commutateur (S) et qui ont des caractéristiques différentes, dont l'un au moins n'est pas présent en permanence pour l'obtention de la grandeur commandée (x) dans la voie de transmission du signal de la différence de réglage (d; φd), et du type dans lequel le commutateur (S) servant à la commutation des groupes fonctionnels (61, 62; 6i; F1, F2) est commuté en fonction de critères prédéterminés lors de chaque modification instantanée du vecteur d'état, associée aux critères,
caractérisé par le fait qu'un groupe fonctionnel (F1) a une caractéristique non amortie et qu'un autre groupe fonctionnel (F2) a une caractéristique amortie et que le commutateur (S) commute entre les deux groupes fonctionnels (F1, F2) lors d'un changement de signe de la différence de réglage.

2. Système de régulation dynamique suivant la revendication 1, caractérisé par le fait que les groupes fonctionnels (61, 62, 6i; F1, F2) ayant des caractéristiques différentes sont montés en parallèle.

3. Système de régulation dynamique suivant la revendication 1 ou 2, caractérisé par le fait que le circuit de réglage comporte un commutateur (S) servant à commuter les groupes fonctionnels (61, 62, 6i, F1, F2) ayant des caractéristiques différentes.

4. Système de régulation dynamique suivant l'une des revendications 1 à 3, caractérisé par le fait que l'un des groupes fonctionnels (61, 62, 6i; F1, F2) ayant des caractéristiques différentes est présent pour l'obtention de la grandeur de commande (y) dans la voie de transmission du signal de la différence de réglage (d; φd).

5. Système de régulation dynamique suivant l'une des revendications 1 à 3, caractérisé par le fait qu'au moins deux des groupes fonctionnels (61, 62, 6i; F1, F2) ayant des caractéristiques différentes sont présents, pour l'obtention de la grandeur de commande (y), parallèlement à la voie de transmission du signal de la différence de réglage (d; φd).

6. Système de régulation dynamique suivant l'une des revendications 1 à 5, caractérisé par le fait que le commutateur (S) peut être commuté en fonction de l'état du systéme asservi (4, 5; VCO) et/ou du dispositife comparateur (2; PD) et/ou du dispositif de détection ou de mesure (1; T) et/ou de paramètres du système de régulation et/ou de grandeurs parasites (z) et/ou de la grandeur de consigne (w) et/ou en fonction du temps.

7. Système de régulation dynamique suivant l'une des revendications 1 à 6, caractérisé par le fait que le commutateur (S) peut être commuté d'une manière discrète ou continue.

8. Système de régulation dynamique suivant l'une des revendications 1 à 7, caractérisé par le fait que les groupes fonctionnels (61, 62, 6i; F1, F2) ayant des caractéristiques différentes sont des filtres (F1, F2) ayant des caractéristiques différentes.

9. Système de régulation dynamique suivant l'une des revendications 1 à 7, caractérisé par le fait que les groupes fonctionnels (61, 62, 6i; F1, F2) ayant des caractéristiques différentes sont des circuits d'entrée du dispositif de réglage (4; I1, I2, S1, S2) à système asservi (5; VCO).

10. Système de régulation dynamique suivant l'une des revendications 1 à 9, caractérisé par le fait que les groupes fonctionnels (61, 62, 6i; F1, F2) ayant des caractéristiques différentes sont formés par un groupe fonctionnel qui a une caractéristique et auquel peut être appliquée, à l'aide d'un commutateur (S), au moins une caractéristique partielle pour l'obtention d'une caractéristique globale différente.

11. Système de régulation dynamique suivant l'une des revendications 1 à 10, caractérisé par sa mise en oeuvre sous la forme d'un système numérique.

12. Système de régulation dynamique suivant l'une des revendications 1 à 10, caractérisé par sa mise en oeuvre sous la forme d'un système analogique.

13. Système de régulation dynamique suivant l'une des revendications 1 à 12, caractérisé par sa mise en oeuvre sous la forme d'un circuit Phase-Locked-Loop (boucle à verrouillage de phases (PLL), dans lequel le dispositif comparateur (2) est un détecteur de phase (PD), le dispositif de correction (6) est constitué par au moins un filtre (F1, F2), le dispositif de réglage à systeme asservi (4, 5) est un oscillateur (VCO) commandé en tension et ayant un circuit d'entrée, une oscillation (ωx) étant utilisée en tant que grandeur commandée (x), et le dispositif de mesure (1) est un fréquencemètre (T).

14. Système de régulation dynamique suivant la revendication 13, caractérisé par le fait que le ou les filtres (F1, F2; C) présentent des caractéristiques de filtres passe-bas.

15. Système de régulation dynamique suivant l'une des revendications 13 et 14, caractérisé par le fait que la caractéristique de filtre passe-bas des filtres (F1, F2) est obtenue à l'aide de circuits d'intégration ou de maintien (C).

16. Système de régulation dynamique suivant l'une des revendications 13 à 15, caractérisé par le fait que le circuit de correction (F1,F2,S) est constitué de deux filtres parallèles (F1,F2) qui ont des caractéristiques de filtrage différentes, et qui peuvent être commutés à l'aide d'un commutateur (S).

17. Système de régulation dynamique suivant l'une des revendications 13 à 15, caractérisé par le fait que le circuit de correction (F1, F2, S) est un filtre qui a une caractéristique de filtrage et qui peut être commuté sur une autre caractéristique de filtrage à l'aide d'un commutateur (S).

18. Système de régulation dynamique suivant l'une des revendications 13 à 15, caractérisé par le fait qu'il est prévu, comme filtre, un circuit d'intégration ou de maintien (C) et que le circuit d'entrée de l'oscillateur (VCO) commandé en tension est formé par deux sources de courant de référence (T2, T3, T11 à T14, R11, R13), qui sont commandée en tension et qui sont commutables à l'aide d'un commutateur (S; T11, T14).

19. Système de régulation dynamique suivant l'une des revendications 13 à 15, caractérisé par le fait qu'il est prévu, comme filtre, un circuit d'intégration ou de maintien (C) et que le circuit d'entrée de l'oscillateur (VCO) commandé en tension est constitué d'une source de courant de référence (T1 à T5, R, R5; T10, T20, T31, T32, T40, T50, R10, R50), qui est commandée en tension, qui fournit un courant de référence, et qui peut être commutée sur un autre courant de référence à l'aide d'un commutateur (S; T5; T50).

20. Système de régulation dynamique suivant l'une des revendications 13 à 19, caractérisé par le fait que le commutateur (S) peut être commuté en fonction de l'état du détecteur de phase (PD).

21. Système de régulation dynamique suivant l'une des revendications 13 à 20, caractérisé par le fait que le commutateur (S) peut être commuté en fonction du signe de la différence de réglage (φd) qui doit être formée par le détecteur de phase (PD).

22. Système de régulation dynamique suivant l'une des revendications 13 à 21, caractérisé par le fait que l'oscillateur (VCO) commandé en tension comporte une capacité (C1; C11), qui peut être chargée et déchargée par des sources de courant commutables (I1, I2; T10, T20, T31, T32, R10), et un réseau de contrôle (K) qui peut être commandé par la capacité (C1; C11) et qui est relié à des commutateurs (S1, S2; T35, T38, T39) de sources de courant, destinés à la commutation des sources de courant (I1, I2; T10, T20, T31, T32, R10), et à la sortie (VCOA) de l'oscillateur (VCO) commandé en tension.

23. Système de régulation dynamique suivant l'une des revendications 13 à 22, caractérisé par le fait que le réseau de contrôle (K) comporte un déclencheur de Schmitt (ST), qui détermine l'état de sortie de l'oscillateur (VCO) commandé en tension, et des étages inverseurs (T60 à T63).

24. Système de régulation dynamique suivant l'une des revendications 13 à 23, caractérisé par le fait que les commutateurs (S1, S2; T35, T38, T39) des sources de courant sont reliés à des sorties de commande antivalentes du réseau de contrôle (K).

25. Système de régulation dynamique suivant l'une des revendications 13 à 24, caractérisé par le fait que la source de courant de référence commandée en tension est formée par un transistor de sortie (T3) d'un premier type, dont le circuit de sortie fournit un courant de référence et dont le circuit d'entrée est commandé par le circuit d'entrée d'un transistor (T2) du même type, qui constitue avec ce transistor (T3) un miroir de courant et qui est monté en diode, et
dans le circuit de sortie de ce transistor sont disposées deux branches parallèles comportant chacune deux circuits de sortie, branchés chacun en série avec une résistance (R11, R13), de deux transistors (T11 à T14), les transistors (T11, T12) de la première branche étant du second type et les transistors (T13, T14) de la seconde branche étant des premier et second types, et
dans les deux branches, respectivement deux transistors, à savoir d'une part deux transistors (T11, T13) du même type, et d'autre part deux transistors (T12, T14) des premier et second types, comportent des circuits d'entrée identiques, qui forment les entrées (VCOE, F1/F2) de la source de courant de référence commandée en tension, et les résistances (R11, R13) sont différentes.

26. Système de régulation dynamique suivant l'une des revendications 13 à 24, caractérisé par le fait que la source de courant de référence commandée en tension est formée par un transistor de sortie (T3, T31, T32) du premier type, dont le circuit de sortie fournit un courant de référence et dont une borne du circuit de sortie est reliée à une borne du circuit de sortie d'un transistor (T2, T20) du même type, qui forme avec ce transistor (T3, T31, T32) un miroir de courant et qui est monté en diode,
qu'entre les circuits d'entrée des transistors (T2, T3, T20, T31, T32) est monté un circuit de sortie d'un autre transistor (T4, T40) du même type et qu'entre les points de jonction du circuit de sortie de l'autre transistor (T4, T40) et du circuit d'entrée du transistor de sortie (T3, T31, T32), d'une part, et des circuits de sortie du transistor de sortie (T3, T31, T32) et du transistor (T2, T20) monté en diode, d'autre part, le circuit de sortie d'un transistor de commutation (T5, T50) du premier type est branché en série avec une résistance (R5, R50),
qu'en série avec le circuit de sortie du transistor (T2, T20) monté en diode sont branchés le circuit de sortie d'un transistor d'entrée (T1, T10) du second type et une résistance (R1, R10), dont la borne libre est reliée au circuit d'entrée de l'autre transistor (T4, T40), et
que les entrées du transistor d'entrée (T1, T10) et du transistor de commutation (T5, T50) forment les entrées (VCOE, F1/F2) de la source de courant de référence commandée en tension.

27. Système de régulation dynamique suivant l'une des revendications 13 à 26, caractérisé par le fait que la source de courant de référence commandée en tension comporte deux transistors de sortie parallèles (T31, T32), dont l'un (T32) est relié, par l'intermédiaire d'un commutateur électronique (S1; T35), à une borne d'une capacité (C1, C11) et au circuit de sortie d'un premier transistor (T36) du miroir de courant, qui est commandable par l'intermédiaire d'un autre commutateur électronique (S2; T38, T39), transistor avec lequel est branché en série le circuit de sortie d'un second transistor (T37) du miroir de courant, tandis qu'à ces transistors sont associés des transistors respectifs (T33, T34) qui sont montés en diodes, et dont les circuits de sortie sont branchés en série entre eux et en série avec le circuit de sortie de l'autre transistor de sortie (T31) de la source de courant de référence commandée en tension.

28. Système de régulation dynamique suivant l'une des revendications 13 à 27, caractérisé par sa mise en oeuvre en tant que système numérique.

29. Système de régulation dynamique suivant l'une des revendications 13 à 27, caractérisé par sa mise en oeuvre en tant que système analogique.

30. Procédé pour faire fonctionner un système de régulation dynamique suivant l'une des revendications 1 à 12, caractérisé par le fait que l'on commute le commutateur (S) en fonction de l'état du système asservé (4, 5; VCO) et/ou de paramètres du système de régulation et/ou du dispositif comparateur (2; PD) et/ou du dispositif de détection ou de mesure (1; T) et/ou de grandeurs parasites (z) et/ou de la grandeur de consigne (b) et/ou en fonction du temps.

31. Procédé suivant la revendication 30 pour faire fonctionner un système de régulation dynamique suivant l'une des revendications 1 à 12, caractérisé par le fait que l'on commute le commutateur (S) de façon discrète ou continue.

32. Procédé pour faire fonctionner un système de régulation dynamique suivant l'une des revendications 13 à 29, caractérisé par le fait que l'on commute le commutateur (S) en fonction de l'état du détecteur de phase (PD), notamment en fonction du signe de la différence de réglage (φd) qui doit être formée par le détecteur de phase (PD).

33. Procédé suivant la revendication 32 pour faire fonctionner un système de régulation dynamique suivant l'une des revendications 13 à 29, caractérisé par le fait que l'on commute les commutateurs (S1, S2; T35, T38, T39) des sources de courant, pour charger et décharger de la capacité (C1; C11) de l'oscillateur (VCO) commandé en tension, à partir de sorties antivalentes de commande du réseau de contrôle (K; ST).
